# EUROPEAN PATENT SPECIFICATION

(11) **EP 1 225 664 B1**
(45) Date of publication and mention of the grant of the patent: **11.10.2006**
(21) Application number: 01310914.5
(22) Date of filing: 27.12.2001
(51) Int. Cl.: H01R 43/24, H01R 9/05

(54) **Electrical component with conductive tracks**
Elektrisches Bauelement mit Leiterzügen
Composant électrique avec pistes conductrices

(30) Priority: 22.01.2001 GB 0101597
(43) Date of publication of application: 24.07.2002
(73) Proprietor: ITT MANUFACTURING ENTERPRISES, INC., Wilmington, Delaware 19801 (US)
(72) Inventor: Gray, Ian James Stafford, Nr Winchester, Hampshire SO21 3AN (GB); Impay, John, Syston, Leicestershire LE7 2HA (GB)
(74) Representative: Ertl, Nicholas Justin

(56) References cited:
- EP-A- 0 924 809
- WO-A-00/28627
- DE-A- 19 925 286
- DE-C- 19 716 139
- US-A- 6 050 828
- US-A- 6 132 244

## Description

This invention relates to electrical components having a body which defines on its surface isolated conducting tracks. The component may comprise an interface component having terminals which are connected together by the tracks. As one example, the interface component may be for attachment to a printed circuit board (PCB), to enable the production of an electrical interface between the PCB and one or more signal connectors, for example radio frequency (RF) connectors.

The applicant's European patent EP 0865120 discloses an interface component comprising a plastics body which connects to a PCB and which provides connection paths to a number of RF connectors. The plastics body is moulded in a two-stage process, such that different parts of the outer surface of the interface component are defined by different plastics materials. A selective plating process plates one of the types of plastics material, so that conductive paths are defined between the RF connectors and feet of the interface component which attach to the printed circuit board. This provides a low cost manufacturing process for the interface component.

One difficulty which may be encountered in practice is that the selective plating process cannot be guaranteed to provide no adhesion of conductive material to the areas of the body which are not to be plated. This may be a particular disadvantage for small structures and in mass production processes.

DE 197 16 139 discloses a coaxial connector for interfacing between a PCB and coaxial connectors, and uses plated conducting portions on the outer surface.

According to the invention, there is provided a method of manufacturing an electrical component having at least two conductive tracks formed on the surface of a body of the component, the method comprising:
moulding a structure having a three dimensional shape from plastics material, the shape defining first and second spaced portions connected by one or more connecting tabs;
plating the structure with a conductive layer;
carrying out a further moulding step which at least partially fills the spacing between the first and second portions, wherein the connecting tabs project outside an outer surface of the component; and
removing the connecting tabs, thereby isolating the first and second portions from each other.

In the method of the invention, a three-dimensional structure is moulded which defines first and second conductive portions. These are connected by tabs, but are otherwise separated from each other, so that they may define isolated electrical areas. The structure is plated before the spacing is filled with insulating (dielectric) material. Therefore, the insulating parts of the component are not subjected to the plating process, and there is therefore no risk of short circuit between the plated areas. This also enables the plated area to pass throughout the interface component, rather than only on the outer surface. This can be used to improve signal shielding between different regions of the interface component.

The tabs maintain the structural integrity of the initial moulded structure, and are arranged to lie outside the desired outer profile of the component. The tabs therefore hold the structure together during the further moulding step, but can then be removed to enable different areas of the interface component to be electrically isolated from each other.

In one example, the electrical component is an interface component for interfacing between a printed circuit board and a signal connector having at least two terminals. In this case, the shape defines a first board contact area for connection to the printed circuit board and a first connector contact area for connection to a first terminal of the signal connector, the first board contact area and first connector contact area being connected together by one of the portions of the structure. In this arrangement, the plated areas of the component, define the connection between a PCB mount and a signal connector.

The structure may further comprise a void between the location of a second board contact area for connection to the printed circuit board and the location of the signal connector; the further moulding step then at least partially fills the void with plastics material; and the method further comprises the step of forming an electrical connection between the second board contact area and a second terminal of the signal connector through the void.

This void enables a second connection to be made between the signal connector and the PCB which is isolated from the plated structure. Thus, the interface component defines two connections between the PCB and the signal connector.

The interface component preferably comprises a plurality of signal connectors, with a respective void being provided to enable connection of the second terminal of each signal connector to the PCB.

The method described above may be used to make an electrical component comprising a three dimensional structure having an outer surface, in which the structure is formed from two different moulded components, the components comprising a first moulded component comprising a plated plastics material, the first moulded component defining at least two portions of the structure which do not contact each other, the plating of the two portions defining spaced conducting areas on the outer surface and wherein the plating of the first moulded component covers substantially all surfaces of the first moulded component including surfaces of the first moulded component which are on the outer surface and surfaces which are internal to the structure; and a second moulded component comprising an unplated plastics material which at least partially fills the spacing between the at least two portions.

As described above, the plating of part of the component both internally and externally enables electromagnetic shielding to be achieved between different areas of the interface component.

The component may comprise an interface component for interfacing between a printed circuit board and a signal connector having at least two terminals, comprising the three dimensional structure for attachment to a printed circuit board and a signal connector having at least two terminals, wherein the structure has a first three dimensional region plated plastics material and a second unplated region of plastics material, and wherein the plated region defines interconnections between a first board contact area for connection to the printed circuit board and a first terminal of the signal connector, wherein the second region defines a passage between a second board contact area for connection to the printed circuit board and the signal connector, such that the second board contact area is defined within an area of unplated plastics material, a conductive path being defined between the second board contact area and a second terminal of the signal connector.

The (or each) signal connector may comprise a coaxial connector, having an outer sheath which defines the first terminal, and an inner contact which defines the second terminal. The inner contact can then be housed within the passageway so that connection can be made through the interface component to the second board contact area.

An example of the invention will now be described in detail with reference to the accompanying drawings, in which:
Figure 1 shows an interface component according to the invention;
Figure 2 shows a moulded structure used in the manufacture of the component of Figure 1;
Figure 3 shows the component of Figure 2 after a second moulding step;
Figure 4 shows the component of Figure 3 after insertion of electrical connections;
Figure 5 shows the underside of the component at the same manufacturing stage as that of Figure 4; and
Figure 6 is a cross section through the interface component of the invention.

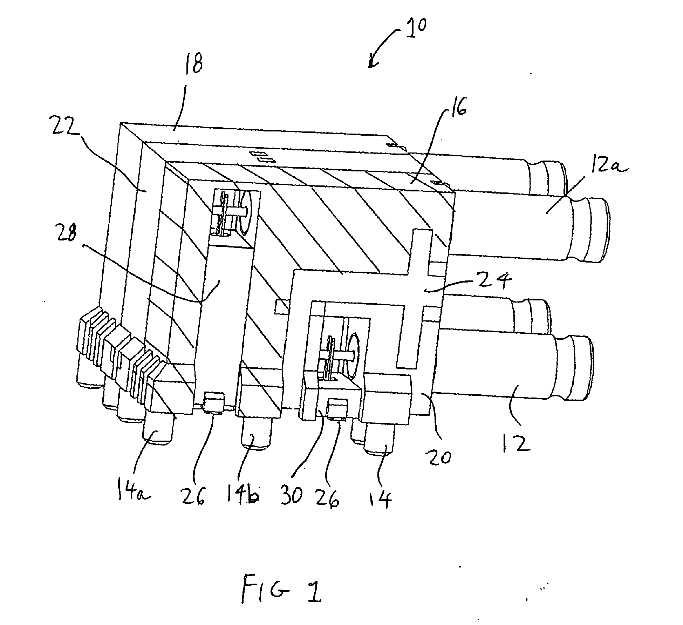

Figure 1 shows a component 10 of the invention, designed as an interface component (or adaptor) for attachment to a PCB, which is formed as a Moulded Interconnect Device (MID). MID technology allows the component to be moulded in plastics, with selectively plated areas, so that certain areas can carry an electrical signal.

The adaptor shown in Figure 1 is for connecting four coaxial connectors 12 to a printed circuit board. Each coaxial connector 12 comprises an outer sheath and a central inner pin, and the function of the interface component 10 is to provide separate isolated connections of these two terminals of the connectors 12 to the PCB using conductive areas of plating.

In some examples, the outer sheath of each coaxial connector 12 is to be connected to earth, and therefore the outer sheaths do not in fact require separate connections to the PCB. They may instead all be connected together. Although the design described below enables the outer sheath of each coaxial connector 12 to be provided with a separate isolated path to the printed circuit board, it also allows all of the conductive areas to be connected together with a simple modification.

In the example of Figure 1, the component 10 is for attachment to a printed circuit board by means of pins 14. These may be considered as a first board contact area. Each of these pins 14 connects to one or more of the outer sheaths of the coaxial connectors 12. For example, pins 14a and 14b connect to the outer sheath of the coaxial connector 12a by means of the hatched conductive area 16. This conductive area 16 is separated from other conductive areas 18, 20 by insulating areas 22, 24. Thus, the outer surface of the interface component 10 comprises conductive and non-conductive regions, with the conductive regions defining the connection between the outer sheaths of the coaxial connectors 12 and the PCB pins 14.

The interface component further has second board contact areas 26 for connection to the PCB. These contact areas 26 are isolated from the pins 14 and are therefore separated from the conductive areas 16, 18, 20 by insulating areas 28, 30. In the example shown, the second contact areas 26 are formed as surface connect areas for surface connection to the printed circuit board.

In accordance with the invention, the conductive areas 16, 18, 20 are formed by a plating process before the moulding of the insulating regions 22, 24, 28, 30. Furthermore, the plating is not only on the outer surface of the interface component 10, but runs throughout the body.

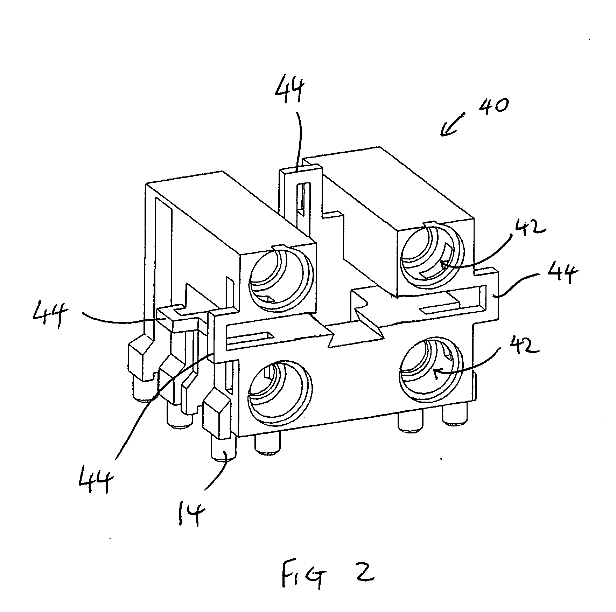

The manufacturing process used to form the interface component of Figure 1 will now be described with reference to Figures 2 to 5.

Figure 2 shows a first moulded structure, which is formed at the first step in the manufacture of the interface component. The structure 40 has a complex three dimensional shape, which defines the pins 14 as well as recesses 42 for receiving the coaxial connectors. The pins 14 may be considered as first board contacts for connection to the printed circuit board.

The shape of the moulded structure 40 provides separate sections of material connecting each recess 42 to an associated pin or pins 14. These separate sections of material are connected together by additional tabs 44, which are required to prevent the structure falling apart. These tabs connect together regions of the structure 40 which would otherwise comprise completely separate moulded parts. This maintains the structural integrity of the moulded article 40. The tabs 44 lie outside the desired outer profile of the component, so that they may be removed at a subsequent stage in the manufacture, as will be described below.

The recesses 42 extend into a void which passes through the structure to the location of the second contact area 26. Thus, a passageway is defined through which connections can be made to the coaxial connector, isolated from the structure 40.

In the example shown in Figure 2, the lower two recesses 42 are connected together, whereas the upper two recesses 42 can be isolated by removal of the tabs 44.

The structure shown in Figure 2 is plated with a conductive coating. This results in plating of all exposed surfaces of the structure. This includes the pins 14, the inner surfaces of the recesses 42 and all other internal and external surfaces. The plated recesses 42 then provide a contact area for connection to a coaxial connector to be inserted into the recesses 42.

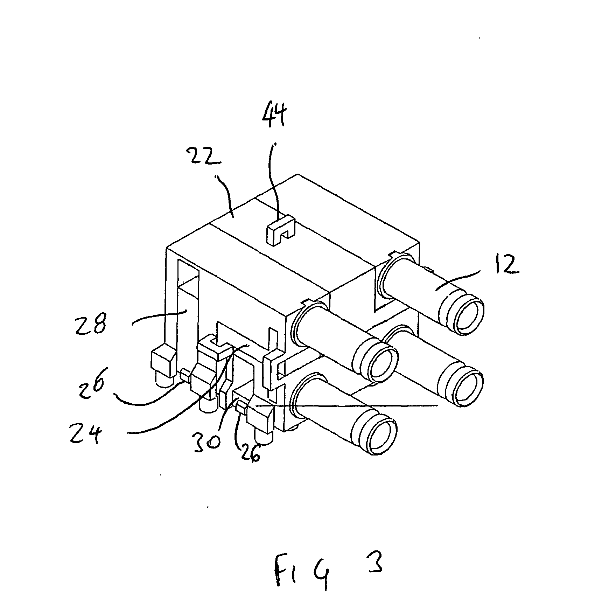

The coaxial connectors 12 are then inserted into place. The fitting of the coaxial connectors 12 into the recesses 42 provides electrical connection between the outer sheath of each connector 12 and the respective part of the plated moulded structure. The moulded structure, with the connectors 12 in place, is then subjected to an over moulding step. This defines the insulating areas 22, 24, 28, 30 identified with reference to Figure 1. The resulting structure is shown in Figure 3.

The areas 28 and 30 partially fill a passageway between the second PCB contacts 26 and the recesses 42. These areas of insulating material provide a shield around electrical conductors extending between the second contact 26 and the central pin of each coaxial connector 12.

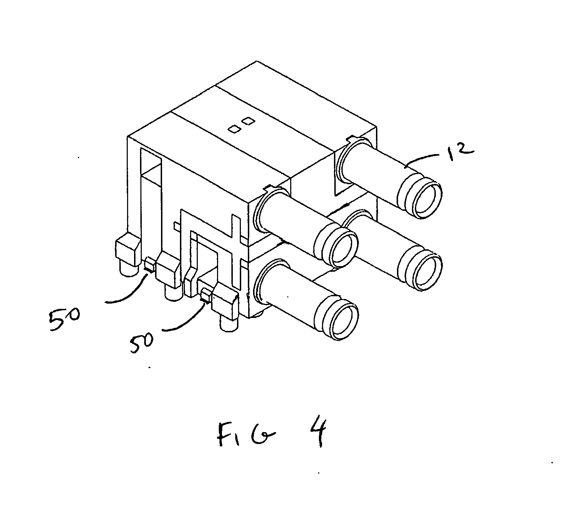

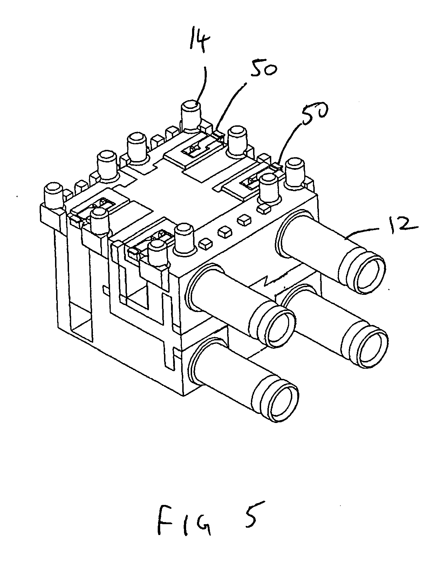

After the second moulding step, the tabs can be removed, and contact members 50 can be inserted, to complete the connection of the central pins of each coaxial connector 12 to the second contact 26. This is shown in Figure 4. Figure 5 shows the underside of the component of Figure 4. If the electrical connections to the outer sheaths of the coaxial connectors 12 do not need to be isolated from each other, the connecting tabs 44 may be left in place. In this way, a single design of component enables two different functions to be implemented.

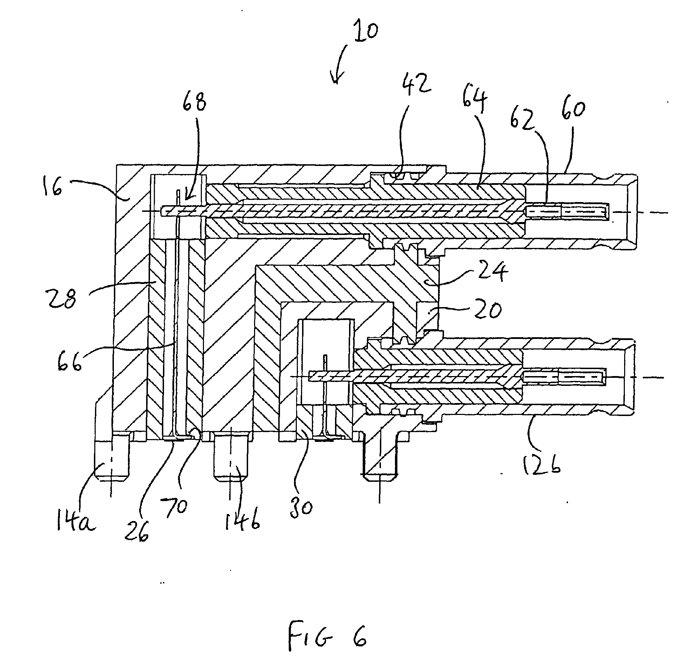

In order to show more clearly how the connections to the coaxial connectors 12 are made, Figure 6 shows a cross section through the interface component. The outer sheath 60 of the coaxial connector 12a is connected by the plated area 16 to the pins 14a and 14b. The view in Figure 6 clearly shows a right-angled void for each coaxial connector 12 extending between the recess 42 and the contact 26. The coaxial connector 12 comprises a central pin 62 which is isolated from the outer sheath by an annular insulator 64. The central pin 62 extends to the elbow of the right-angled void. This enables an elongate connector 66 to be inserted at the location of the second contact 26 to provide an interference fit 68. As will be apparent from the above description, the central pin 62 is in place before the moulding of the insulating parts and therefore the interference fit 68 needs to be made by inserting the elongate connector 66. As shown in Figure 1, the connector 66 comprises a pair of resilient jaws which engage the central pin 62 to form the interference fit 68.

The elongate connector 66 is surrounded by insulating material 28. When the second moulding stage is carried out, the mould has a configuration to define the area 28 as an annular column, and the mould furthermore leaves the elbow region empty to enable the interference fit to be formed. The base of the column 28 has a small recessed portion 70 which enables the connector 66 to provide a flush connection surface 26 suitable for surface mounting to a printed circuit board.

The interface component of the invention is particularly suitable for connecting RF coaxial connectors to a printed circuit board, and provides improved electromagnetic shielding between the different coaxial connectors of each interface component.

In the example described above, the connections to the printed circuit board are defined as a series of pins and a series of surface mount areas. Of course, any suitable arrangement of connections may be provided. For example, all of the PCB connections may be surface mount connections, or alternatively the elongate connectors 66 may be provided with ends which define pins to pass through the printed circuit board.

The material of the moulded structure of Figure 2 will be selected to enable a suitable plating process to be carried out. The possible choice of materials and the plating process to be used will be apparent to those skilled in the art. The material used in the second moulding process does not require subsequent plating. Consequently, the material used in this process may be selected to optimise the dielectric properties of the material, thereby providing insulation between the conductive parts of the structure. Again, the choice of materials used will be a matter of routine design choice for those skilled in the art.

Although the invention has been described in detail in connection with a PCB connector for two-terminal coaxial connectors, the principles of the invention may equally be applied to any device on which separate conducting tracks are required. For example, the method of the invention may be used to form a patch antenna.

## Claims

1. A method of manufacturing an electrical component having at least two conductive tracks (16) formed on the surface of a body of the component, **characterised in that** the method comprises:
moulding a structure (40) having a three dimensional shape from plastics material, the shape defining first and second spaced portions connected by one or more connecting tabs (44);
plating the structure with a conductive layer;
carrying out a further moulding step which at least partially fills the spacing between the first and second portions, wherein the connecting tabs (44) project outside an outer surface of the component; and
removing the connecting tabs (44), thereby isolating the first and second portions from each other.

2. A method as claimed in claim 1, wherein the electrical component is an interface component for interfacing between a printed circuit board and a signal connector (12) having at least two terminals (60, 62), and wherein the shape defines a first board contact area (14) for connection to the printed circuit board and a first connector contact area for connection to a first terminal (60) of the signal connector, the first board contact area (14) and first connector contact area being connected together by one of the portions of the structure.

3. A method as claimed in claim 2, wherein the structure is moulded to define a void (42) between the location of a second board contact area (26) for connection to the printed circuit board and the location of the signal connector (12), wherein the further moulding step at least partially fills the void with plastics material (28), and wherein the method further comprises the step of forming an electrical connection (68) between the second board contact area (26) and a second terminal (62) of the signal connector through the void.

4. A method as claimed in claim 3, wherein the interface component comprises a plurality of signal connectors (12), the structure having a respective void (42) between the location of each signal connector (12) and an associated second board contact area.

5. A method as claimed in claim 3 or 4, wherein the signal connector comprises an outer sheath (60) and an inner contact (62), and wherein the connector is inserted into the void (42) before the further moulding step.

6. A method as claimed in any one of claims 3 to 5, wherein the further moulding step partially fills the void (42) at the vicinity of the second board contact area (50) with an annular column, and wherein the step of forming an electrical connection comprises inserting an elongate connector in the cavity of the annular column, which engages the second terminal of the connector at one end and defines the second board contact at the other end.

## Patentansprüche

1. Verfahren zur Herstellung eines elektrischen Bauelements, das mindestens zwei Leiterbahnen (16) aufweist, die auf einer Oberfläche eines Körpers des Bauelements gebildet sind, **dadurch gekennzeichnet, dass** das Verfahren enthält:
Formen einer Struktur (40), die eine dreidimensionale Form hat, aus Kunststoffmaterial, welche Form einen ersten und einen zweiten beanstandeten Abschnitt bildet, die durch eine oder mehrere Verbindungszungen (44) verbunden sind;
Plattieren der Struktur mit einer leitfähigen Schicht;
Durchführen eines weiteren Formungsschrittes, der den Abstand zwischen dem ersten und den zweiten Abschnitt zumindest teilweise füllt, wobei die Verbindungszungen (44) außerhalb einer äußeren Oberfläche des Bauelements vorspringen; und
Entfernen der Verbindungszungen (44), wodurch der erste und der zweite Abschnitt voneinander isoliert werden.

2. Verfahren nach Anspruch 1, bei welchem das elektrische Bauelement ein Schnittstellen-Bauelement für die Schnittstellenverbindung zwischen einer gedruckten Schaltungsplatine und einem Signal-Steckverbinder (12) mit mindestens zwei Anschlüssen (60, 62) ist und bei welchem die Form eine erste Platinen-Kontaktfläche (14) zur Verbindung mit der gedruckten Schaltungsplatine und eine erste Steckverbinder-Kontaktfläche zur Verbindung mit einem ersten Anschluss (60) des Signal-Steckverbinders bildet, wobei die erste Platinen-Kontaktfläche (14) und die erste Steckverbinder-Kontaktfläche durch einen der Abschnitte der Struktur miteinander verbunden werden.

3. Verfahren nach Anspruch 2, bei welchem die Struktur so geformt ist, dass sie einen Hohlraum (42) zwischen der Position einer zweiten Platinen-Kontaktfläche (26) zur Verbindung mit der gedruckten Schaltungsplatine und der Position des Signal-Steckverbinders (12) bildet, wobei der weitere Formungsschritt den Hohlraum zumindest teilweise mit Kunststoffmaterial (28) füllt und wobei das Verfahren ferner den Schritt des Bildens einer elektrischen Verbindung (68) zwischen der zweiten Platinen-Kontaktfläche (26) und einem zweiten Anschluss (62) des Signal-Steckverbinders durch den Hohlraum enthält.

4. Verfahren nach Anspruch 3, bei welchem das Schnittstellen-Bauelement eine Vielzahl von Signal-Steckverbindern (12) enthält, wobei die Struktur einen jeweiligen Hohlraum (42) zwischen der Position jedes Signal-Steckverbinders (12) und einer zugehörigen zweiten Platinen-Kontaktfläche aufweist.

5. Verfahren nach Anspruch 3 oder 4, bei welchem der Signal-Steckverbinder eine äußere Umhüllung (60) und einen inneren Kontakt (62) aufweist und bei welchem der Steckverbinder vor dem weiteren Formungsschritt in den Hohlraum (42) eingeführt wird.

6. Verfahren nach einem der Ansprüche 3 bis 5, bei welchem der weitere Formungsschritt den Hohlraum (42) in der Nachbarschaft der zweiten Platinen-Kontaktfläche (50) mit einer ringförmigen Säule teilweise füllt und bei welchem der Schritt des Bildens einer elektrischen Verbindung das Einführen eines länglichen Steckverbinders in den Hohlraum in der ringförmigen Säule umfasst, der an einem Ende mit dem zweiten Anschluss des Steckverbinders in Eingriff kommt und am anderen Ende den zweiten Platinenkontakt bildet.

## Revendications

1. Procédé de fabrication d'un composant électrique qui présente au moins deux pistes conductrices (16) formées sur la surface d'un corps du composant, **caractérisé en ce que** le procédé comprend les étapes qui consistent à :
mouler une structure (40) de forme tridimensionnelle à partir d'une matière plastique, la forme définissant une première et une deuxième partie espacées l'une de l'autre et reliées par une ou plusieurs pattes de connections (44),
plaquer une couche conductrice sur la structure,
réaliser une autre étape de moulage qui remplit au moins une partie de l'écart entré la première et la deuxième partie, les pattes de connections (44) débordant à l'extérieur de la surface extérieure du composant et
enlever les pattes de connexion (44) pour ainsi isoler l'une de l'autre la première et la deuxième partie.

2. Procédé selon la revendication 1, dans lequel le composant électrique est un composant d'interface qui assure l'interface entre une carte de circuit imprimé et un connecteur de signaux (12) doté d'au moins deux bornes (60, 62), la forme définissant avec la carte une première zone de contact (14) destinée à assurer la connexion avec la carte de circuit imprimé et avec les connecteurs une première zone de contact qui assure la connexion d'une première borne (60) du connecteur de signaux, la première zone (14) de contact avec la carte et la première zone de contact avec le connecteur étant reliées l'une à l'autre par une des parties de la structure.

3. Procédé selon la revendication 2, dans laquelle la structure est moulée de manière à définir un vide (42) entre l'emplacement d'une deuxième zone de contact (26) avec la carte destinée à assurer la connexion avec la carte de circuit imprimé et l'emplacement du connecteur de signaux (12), l'étape supplémentaire de moulage remplissant au moins une partie du vide par une matière plastique (28), le procédé comportant en outre l'étape qui consiste à former une connexion électrique (68) entre la deuxième zone de contact (26) avec la carte et une deuxième borne (62) du connecteur de signaux par l'intermédiaire du vide.

4. Procédé selon la revendication 3, dans lequel le composant d'interface comprend plusieurs connecteurs de signaux (12), la structure présentant un vide (42) entre l'emplacement de chaque connecteur respectif de signaux (12) et une deuxième zone associée de contact avec la carte.

5. Procédé selon les revendications 3 ou 4, dans lequel le connecteur de signaux comprend un fourreau extérieur (60) et un contact intérieur (62), le connecteur étant inséré dans le vide (42) avant l'étape supplémentaire de moulage.

6. Procédé selon l'une quelconque des revendications 3 à 5, dans lequel l'étape supplémentaire de moulage remplit une partie du vide (42) au voisinage de la deuxième zone de contact (50) avec la carte par une colonne annulaire, et dans lequel l'étape de formation d'une connexion électrique comprend l'étape qui consiste à insérer dans la cavité de la colonne annulaire un connecteur allongé qui engage la deuxième borne du connecteur à une extrémité et qui définit le deuxième contact avec la carte à son autre extrémité.
